# EUROPEAN PATENT APPLICATION

(11) **EP 4 451 345 A1**
(43) Date of publication of application: **23.10.2024**
(21) Application number: 23168527.2
(22) Date of filing: 18.04.2023
(51) Int. Cl.: H01L 31/0232, G02B 5/00, H01L 31/054, H01L 31/056, H01L 31/0352

(54) **INCREASING RESPONSE OF THE QUANTUM SEMICONDUCTOR DEVICE BY EMPLOYING METAMATERIAL STRUCTURE**

(71) Applicant: Valstybinis moksliniu tyrimu institutas Fiziniu ir technologijos mokslu centras, 10257 Vilnius (LT)
(72) Inventor: Cizas, Vladislovas, Vilnius (LT); Redeckas, Karolis, Vilnius (LT); Jakstas, Vytautas, Vilnius (LT); Ignas, Grigelionis, Vilnius (LT); Linas, Minkevicius, Vilnius (LT)
(74) Representative: Pakeniene, Ausra

(57) **Abstract**

The invention proposes a quantum semiconductor device enhanced by two sub-devices, both comprising a metasurface, resulting in collection and redirection of normally incident radiation to fulfil quantum selection rules and the method for efficient optimization of the metasurface. The first sub-device is designed to redirect normally incident radiation. Said first sub-device can be realised in form of the metasurface or complementary metasurface on the bottom interface of the semiconductor structure, or metal-cut complementary metasurface, or a metasurface metal-deposited on a transparent dielectric layer placed at a certain distance below the bottom interface. Said second sub-device, being an optional component, is located on the top of the quantum structure and serves for reflection and additional redirection of the radiation. Said second sub-device can be realised in form of beam reflecting metal layer, or beam reflecting and diffracting grating layer, or beam reflecting and diffracting metasurface or complementary metasurface layer.

## Description

### TECHNICAL FIELD

The invention relates to optoelectric amplitude and phase controlling devices and in particular to manufacturing method of optoelectric amplitude and phase controlling devices and optoelectric amplitude and phase controlling devices for efficient radiation coupling to quantum semiconductor devices.

### BACKGROUND ART

Quantum technology becoming more and more popular for an instantly increasing number of applications including but not limited to solid-state quantum cascade lasers [1], quantum well solar cells [2] or quantum infrared photodetectors [3]. The operation of the above-mentioned devices relies on electronic transitions between the energy subbands or in minibands in the quantum wells. One of the most important intersubband transition principle-based quantum device design requirements, which typically increases fabrication complexity and is one of the largest efficiency-reducing factors, is a need for the coupling of incident radiation. It is very well known that most quantum devices require the fulfilment of quantum selection rules, meaning that normally incident light will not be absorbed by a quantum structure, resulting in a need for such a light to be inclined to have a non-zero electric field component along the quantum structure growth axis to induce intersubband absorption processes [4]. Although most scientific and patent publications are related to quantum well infrared photodetectors (QWIP), the same rules apply to most not so widespread quantum devices including superlattice parametric generators [5], quantum solar cell light trappers [6] etc.

There is already a significant number of solutions for light redirection in quantum devices. Employment of polished facet of the quantum structure by specific (optimal) angle is disclosed in a paper by F.M. Guo et al. [7]. This method turns a substrate of a quantum device into a lossy waveguide, which allows to transfer the electric field with component directed along growth axis of a quantum structure into an active area of the device. Such device is disclosed in US patent No.: US9,577,342. Main disadvantage is low light-structure coupling efficiency. Furthermore, it is not suitable for the array of quantum devices.

Another coupling technique disclosed in US patent No.: US5,075,749 discloses deposition of grating layer on top (reflection-diffraction) or, as disclosed in a paper by G. Hasnain et al. [8], bottom (transmission-diffraction) of a structure. The light passing through (reflected from) the optimised grating is being redirected and has an electric field component along the quantum device growth axis, inducing intersubband transition processes, as disclosed in US patent No.: US7,715,676 B2 and a paper by S.Y. Wang and C.P. Lee [9]. Coupling efficiency, compared to a polishing facet is increased significantly, however additional fabrication processes appear, including etching of a spacer layer in the case of reflection-grating.

Double-oriented gratings may indeed help to solve polarizability drawback of a quantum device with a single-grating couple.

In general, a grating is a device with a periodic structure that is used to diffract and manipulate light or other waves. In the context of quantum devices, a grating can be used to couple photons with the quantum system. However, in some cases, the polarisation of the incoming light can affect the coupling efficiency of the grating in a quantum device with a single-grating. This is because the periodic structure of the grating can act as a polarisation filter, preferentially coupling light with certain polarisations and reducing the coupling efficiency for others. One way to overcome this drawback is to use a double-oriented grating. A double-oriented grating has two sets of periodic structures, oriented at different angles to each other. This allows the grating to couple light with a wider range of polarisations, improving the overall coupling efficiency, as disclosed in a paper by J.Y. Andersson and L. Lundqvist [10]. Employment of pseudo-random reflection-grating may further increase quantum efficiency of a device, as disclosed in US patent No.: US5,506,419. Another proposed solution to increase reflectivity of proper field component into the active area of the quantum device is employment of corrugated structures, as disclosed in US patent application publication No.: US20110042647A1. Complicated fabrication processes are required.

Employment of microlenses for coupling of normally incident radiation into quantum semiconductor devices is another well-known solution, especially for the case of an array of devices. Microlenses allow concentration of the signal, leading to smaller detector requirements, as disclosed in paper by F.S. Pool et al. [11]. Still being wavelength-comparable, such a solution requires very precise alignment procedure. Furthermore, such solution requires additional grating optimization (if applied) compared to normally incident signal case. The employment of sub-wavelength microlenses partially solves the problem, however the resultant efficiency is comparably low, as discussed in the paper by D.W. Prather [12].

Electromagnetic radiation coupling to quantum semiconductor devices can be achieved using a thin layer metasurface. Metasurface comprises an array of metaelements, identical or arranged employing pre-defined regulations, as disclosed in paper by S.B. Glybovski et al. [13]. One of the most interesting aspects of metaelement is its amplitude and phase control possibility by varying geometrical dimensions, shape or other metaelement type dependent parameter, as disclosed in paper by X. Zhang et al. [14]. Although other types of metasurface also fit within the proposed invention, more explicit realisation by employment of single split ring resonators will be described [15]. Such metaelements consist of some shaped structure with at least one gap. In such structures, the incident electromagnetic radiation induces ac current across the conducting part of the metacell which creates at least one dipole at the gap of the metacell (for the case of split ring resonators), that results in electromagnetic radiation emission, as disclosed in paper by Z. Song et al. [16]. The resonant frequency, amplitude and phase of the re-emitted radiation depend on the shape and geometrical dimensions of metacell and gap, as disclosed in paper by M. Hashemi et al. [17]. What is more, employing different metaelements on one metasurface, one can achieve different beam shaping effects (e.g., focusing), as disclosed in paper by F. Aieta et al. [18].

Focusing abilities of the metasurface can be exposed by employing different types of metaelements, as described in the patent US9151891 B2. Furthermore, focusing abilities can be further enhanced by employing bi-layered structures e.g., metasurface-mirror in the case of reflection focusing; metasurface-metasurface in the case of transmission focusing, with dielectric spacer, where the metasurface is said to be arranged based on Fresnel equation, as disclosed in US patent No.: US4,905,014 and US patent No.: US8,390,531. Although such an arrangement is effective for the incident plane wave, reflection of pre-modified beam, would require specific optimization based on antecedent beam modification. Furthermore, seeking simple beam focusing is not equal to focusing the electric field component directed along the growth axis of the quantum structure, thus additional field-component related metasurface optimization is required compared to simple Fresnel equation. Finally, the fabrication of the multi-layered metasurface becomes more complicated due to precise alignment requirement.

Combination of metasurfaces with quantum structures, have not been considered a lot. There has been a proposal to employ dielectric SiO2 metasurface with gradient like nanopillars, where one can control the phase by changing the diameter of the nanopillars, as described in paper by N.K. Dhar et al. [19] and US patent No.: US11222987B2. However, in the above-cited work, the electric field rotation is neither analysed, nor mentioned. Our theoretical analysis showed that the suggested Fresnel equation metaelement arrangement method, although viable, but is far not optimal for the focusing of electric field component directed along the growth axis in the active area of the quantum structure. Furthermore, introduction of dielectric layer on any side of the quantum device adds additional contact placement problems, that although can be solved, would require more complex fabrication procedure, compared to the proposed metal metasurface layers, which in the case of inverted metasurface may simultaneously be employed as contacts.

Prior art concerning coupling of quantum structures with metasurfaces wherein the efficient coupling of a single quantum emitter is done with a metasurface made of gold nanorods, as described in paper by M. Pfeiffer et al. [20]. The metasurface was designed to enhance the spontaneous emission rate of the emitter by controlling the local density of states of the electromagnetic field.

Another prior art, described in paper by V. Rutckaia et al. [21], discloses employment of silicon nanodisks for the efficient coupling of a quantum dot with a metasurface. The metasurface was designed to enhance the absorption of the quantum dot by resonantly coupling it to a high-Q Fano resonance of the metasurface.

The present invention is dedicated to overcoming of the above shortcomings and for producing further advantages over prior art. In particular, the invention aims to solve the problem of inefficient normally incident electromagnetic radiation coupling with quantum semiconductor devices, that require an electric field component to be directed along the growth axis of the quantum structure.

### BRIEF DESCRIPTION OF THE INVENTION

The quantum semiconductor device according to the invention comprises:
- A quantum structure - a structure fabricated to exhibit quantum mechanics effects in an active area of the structure and requiring fulfilment of quantum selection rules;
- A first sub-device, located on the bottom or at a certain distance from said quantum structure, required for redirection of the normal incident radiation into said active area of said quantum structure according to the requirements of quantum selection rules.
- A second sub-device, located on the top of said quantum structure, for reflection and additional redirection, when applied, of the normal incident radiation redirected by the first sub-device. The second device is optional.

Said quantum semiconductor structure comprises an active area sandwiched between spacers and a wide and thick substrate layer used as a basis for the active area and spacer. The spacer fabrication comprises employing molecular beam epitaxy, chemical vapour deposition, or any other technique. Said active area and spacers are usually shaped into small area mesa to increase the performance of the said quantum semiconductor device.

The first sub-device for direction of said normal incident radiation into said active area of said quantum structure, comprises:
- A beam shaping layer which is etched on the bottom part of said substrate of said semiconductor structure according to pre-optimised pattern, or
- A beam shaping layer which is metal-deposited on the bottom part of said substrate of said semiconductor structure according to pre-optimised pattern, i.e., metasurface or complementary metasurface, or
- A beam shaping layer which is metal-cut according to pre-optimised pattern, i.e., a complementary metasurface, and is placed at a certain distance below said substrate of said semiconductor structure, or
- A beam shaping layer which comprises a metal pattern, deposited on transparent dielectric according to pre-optimised pattern, i.e., a metasurface, and is placed at a certain distance below said substrate of said semiconductor structure.

The second, optional, sub-device intended to reflect or reflect, and redirect said normal incident radiation, which was redirected by said first sub-device, comprises:
- a beam reflecting layer, which is metal deposited on the top of said quantum structure and is intended to mirror said normal incident radiation directed into said active area of said quantum semiconductor device by said first sub-device, or
- a beam reflecting and diffracting grating layer, which is spacer etched and metal deposited on the top of said quantum structure and is intended to additionally redirect said normal incident radiation directed into said active area of said quantum semiconductor device by said first sub-device, or
- a beam reflecting and diffracting metasurface or complementary metasurface layer, which is metal deposited on the top of said quantum structure and is intended to additionally reflect and redirect said normal incident radiation directed into said active area of said quantum structure by said first sub-device.

The incident radiation is redirected into the active area of any quantum semiconductor device that requires quantum selection rules to be fulfilled by employment of the beam-shaping and redirecting layers, based on metasurface. The proposed solution can be placed on the said quantum structure or can be employed as a separate device at pre-optimised distance from said quantum structure.

The proposed invention is broadband and can be optimised to operate in both GHz and THz frequency bands. Operation of the proposed invention is based on electrical current induction in the textured conductive layer elements, which in turn induces a dipole-based electric field emission. Optimised design of the said invention not only ensures fulfilment of the quantum selection rules, but also allows to improve the performance of the quantum semiconductor device by increasing signal collection area and focusing the latter into decreased area mesa, increasing signal density in the active area of said quantum structure. The proposed invention ensures the increase of the signal density in the active area to be up to 100 times larger compared to the normally incident radiation density.

### BRIEF DESCRIPTION OF THE DRAWINGS

Features of the invention believed to be novel and inventive are set forth with particularity in the appended claims. The invention itself, however, may be best understood by reference to the following detailed description of the invention, which describes exemplary embodiments, given in non-restrictive examples, of the invention, taken in conjunction with the accompanying drawings, in which:
Fig. 1 a) shows a cross-section view of said quantum semiconductor device with a coupling realised by employing said first sub-device only, displayed in accordance with one of the embodiments of the invention; b) a cross-section view of a quantum device with a coupling realised by employing said first sub-device and said second sub-device, displayed in accordance with another embodiment of the invention.
FIG. 2 shows a cross-section view of said quantum semiconductor device with different realisation variation of coupling techniques for said first sub-device and said second sub-device.

Preferred embodiments of the invention will be described herein below with reference to the drawings. Each figure contains the same numbering for the same or equivalent element.

### DETAILED DESCRIPTION OF THE INVENTION

It should be understood that numerous specific details are presented in order to provide a complete and comprehensible description of the invention embodiment. However, the person skilled in art will understand that the embodiment examples do not limit the application of the invention which can be implemented without these specific instructions. Well-known methods, procedures and components have not been described in detail for the embodiment to avoid misleading. Furthermore, this description should not be considered to be constraining the invention to given embodiment examples but only as one of possible implementations of the invention.

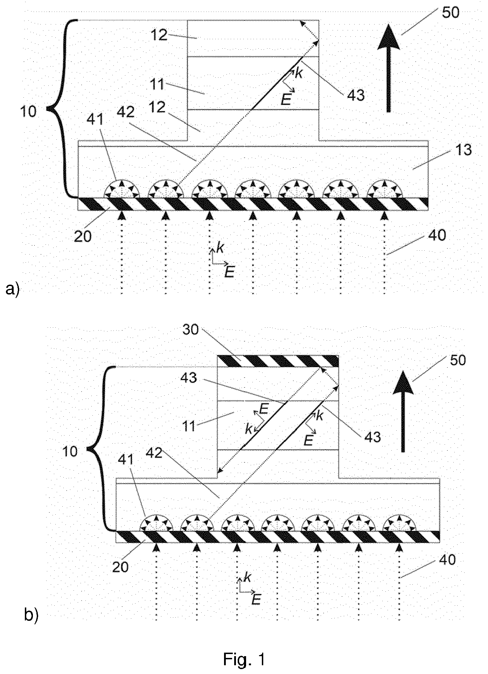

According to the first embodiment of the invention and as shown in Fig. 1.a, a quantum semiconductor device comprises a quantum structure (10) fabricated to exhibit quantum mechanics effects and requiring fulfilment of quantum selection rules, comprising an active area (11) sandwiched between spacers (12) deposited on a wide and thick substrate (13), which is used as a basis for said active area (11) and spacers (12). Being affected by radiation (40), in order to exhibit the quantum mechanics effects, typically, but not limited to intersubband transition in said active area (11) of said quantum structure (10) fulfilment of quantum selection rules is required which in turn requires a field component to be directed along the growth axis (50) in the active area (11) of the quantum structure (10). The quantum semiconductor device further comprises a first sub-device (20) placed below (at the bottom or at a certain pre-optimized distance) said quantum structure (10) to redirect normal incident radiation (40), typically by re-emission (41), so that the redirected radiation (42) in the active area (43) would have an electric field component parallel to the growth axis (50) of said quantum structure (10) according to the requirements of quantum selection rules. Area of the first sub-device (20) can be much larger compared to the mesa area of said quantum structure (10) to collect and redirect the incident radiation into smaller area (when required).

According to the second embodiment of the invention and as shown in Fig. 1.b, the quantum structure (10) may optionally comprise a second sub-device (30), for further improving performance of the quantum semiconductor device. The second sub-device (30) can be mounted on the top of the quantum structure (10) and is intended for reflection for further redirection of the normal incident radiation (40), which has already been redirected by the first sub-device (20). The second sub-device (30) ensures that all the radiation reaching the top of said quantum structure (10) will be reflected back into the active area (11).

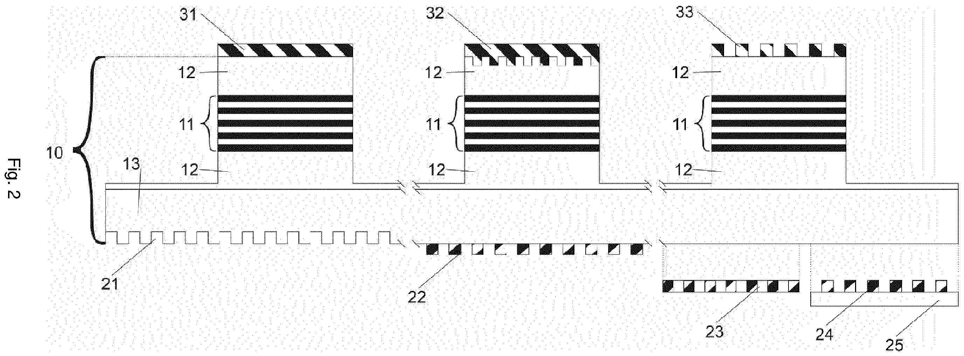

Fig 2., not to scale, shows several examples of the quantum semiconductor devices with different realizations of the first sub-device (20) and the second sub-device (30). When the operational frequency of said device and other conditions allows employment of the conducting substrate (13), said first sub-device (20) can be realised by texturing the substrate (21) to create a beam shaping layer at the bottom part of said conducting substrate (13) according to the pre-optimised pattern. Otherwise, said first sub-device (20) can be realised via metal deposition on the bottom part of said substrate being either a metasurface or a complementary metasurface (22). Furthermore, the first sub-device (20) can be placed at a certain pre-optimised distance below the quantum structure (10). In this case, the first sub-device can be employed as a metal-cut, according to the pre-optimized pattern, complementary metasurface (23) which is typically a conducting material-based plated textured by creating openings, or as a canonic metasurface (24) which comprises a conductive metacell array deposited on some transparent substrate (25) according to the pre-optimized pattern. The second sub-device (30), when employed, is intended to reflect or reflect and redirect said normal incident radiation (40), which was redirected by said first sub-device (20). The second sub-device (30) can be realised as a simple beam reflecting layer (31), which typically, but not limited to, is metal deposited layer intended to mirror said normal incident radiation (40) directed into said active area (11) of said quantum semiconductor structure (10) by said first sub-device (20) or, as beam reflecting and diffracting grating layer (32), which is spacer (12) etched and metal deposited on the top of said quantum structure (1 0).The period and depth of said grating layer (32) is pre-optimised according to the redirection of the normal incident radiation (40) performed by said first sub-device (20). Furthermore, the second sub-device (30) can be realised as beam reflecting and redirecting metasurface or complementary metasurface layer (33), which is pre-optimised according to the redirection of the normal incident radiation (40) performed by the first sub-device (20) and is intended to additionally reflect and redirect said normal incident radiation (40), redirected by said first sub-device (20) into said active area (11) of said quantum structure (10). Being thin, less than a millimetre, metasurface-based variation solutions for said first sub-device (20) and second sub-device (30), would not require additional etching procedure, and for the case of the employment of complementary metasurface layer both sub-devices (20, 30) can also serve as one of the electric contacts for said quantum semiconductor device.

According to the third embodiment of the invention a method of optimization of the metacell arrangement in both said first (20) and second (30) metasurface-based variations of the sub-devices (21, 22, 23, 24, 33) is proposed. The method comprises primary determination of the metacell shape and geometrical parameter optimization for the metasurface (20, 30) to be resonant on the desired operational frequency, in range from GHz to THz.

The next step includes optimisation of phase and amplitude of the electric field component being directed along the growth axis (50) in the active area (11) of said quantum structure (10) for each metacell in the array, considering its position in the metasurface array. The geometrical parameters of each single metacell in the array of the metasurface (21, 22, 23, 24) of the first sub-device (20) are optimised to achieve largest electric field component along the growth axis (50) in the active area (11) of said quantum structure (10). After successful optimization of the metasurface layer (21, 22, 23, 24) of the first sub-device (20), the same procedure is being applied to the second sub-device (30). The resultant signal density in said active area (11) of said quantum structure (10) is expected up to 100 times larger compared to the normally incident radiation density.

Although numerous characteristics and advantages together with structural details and features have been listed in the present description of the invention, the description is provided as an example fulfilment of the invention. Without departing from the principles of the invention, there may be changes in the details, especially in the form, size and layout, in accordance with most widely understood meanings of the concepts and definitions used in claims.

### References:

[1] M.S. VITTIELO, G. SCALARI, B. WILLIAMS, AND P.D. NATALE: "Quantum cascade lasers: 20 years of challenges", Optics Express vol. 23 no. 4, 23 Feb 2015 (2015-02-23), pages 5167-5182, DOI:10.1364/OE.23.005167
[2] I. SAYED AND S.M. BEDAIR: "Quantum well solar cells: principles, recent progress, and potential", IEEE Journal of Photovoltaics vol. 9, no. 2, Mar 2019 (2019-03), pages 402-423, DOI:10.1109/jphotov.2019.2892079
[3] S.D. GUNAPALA, S.V. BANDARA, J.K. LIU, J.M. MUMOLO, SIR B. RAFOL, D.Z. TING, A. SOIBEL, AND C. HILL: "Quantum well infrared photodetector technology and applications", IEEE Journal of Selected Topics in Quantum Electronics vol. 20 no. 6, Nov 2014 (2014-11), pages 154-165, DOI:10.1109/JSTQE.2014.2324538
[4] L.C. WEST AND S.J. EGLASH: "First observation of an extremely large-dipole infrared transition within the conduction band of a GaAs quantum well", Applied Physics Letters vol. 46 no. 12, 15 Jun 1985 (1985-06-15), pages 1156-1157, DOI:10.1063/1.95742
[5] V. ČIŽAS, L. SUBACIUS, N.V. ALEXEEVA, D. SELIUTA, T. HYART, K. KÖHLER, K.N. ALEKSEEV, AND G. VALUŠIS, "Dissipative parametric gain in a GaAs/AIGaAs superlattice", Physical Review Letters vol. 128 no. 23, 8 Jun 2022 (2022-06-08), pages 236802, DOI:10.1103/PhysRevLett.128.236802
[6] C.O. MCPHEETERS AND E.T. YU, "Computational analysis if thin film InGaAs/GaAs quantum well solar cells with back side light trapping structures", Optics Express vol. 20 no. S6, 8 Oct 2012 (2012-10-08), pages A864-A878, DOI:10.1364/OE.20.00A864
[7] F.M. GUO, D.Y. XIONG, W.E. ZHANG AND Z.Q. ZHU, "Analysis and comparison of n-AIGaAs/GaAs QWIPs with different device structures and optical coupling", Infrared Physics & Technology vol. 52 no. 6, Nov 2009 (2009-11), pages 276-280, DOI: 10.1016/j.infrared.2009.05.014
[8] G. HASNAIN, B.F. LEVINE, C.G. BETHEA, R.A. LOGAN, J. WALKER, AND R.J. MALIK, "GaAs/AIGaAs multiquantum well infrared detector arrays using etched gratings", Applied Physics Letters vol. 54 no. 25, 17 Apr 1989 (1989-04-17), pages 2515-2517, DOI: 10.1063/1.101079
[9] S.Y. WANG AND C.P. LEE, "Normal incident long-wavelength quantum well infrared photodetectors using electron intersubband transitions", Applied Physics Letters vol. 71 no. 1, 21 Apr 1997 (1997-04-21), pages 119-121, DOI: 10.1063/1.119446
[10] J.Y. ANDERSSON AND L. LUNDQVIST, "Near-unity quantum efficiency of AIGaAs/GaAs quantum well infrared detectors using a waveguide with a doubly periodic grating coupler", Applied Physics Letters vol. 59 no. 7, 10 Jun 1991 (1991-06-10), pages 857-859, DOI: 10.1063/1.105259
[11] F.S. POOL, D.W. WILSON, P.D. MAKER, R.E. MULLER, J.J. GILL, D.K. SENGUPTA, J.K. LlU, S.V. BANDARA, AND S.D. GUNAPALA, "Fabrication and performance of diffractive optics for quantum well infrared photodetectors", Infrared detectors and focal plane arrays V vol. 3379, 22 Jul 1998 (1998-07-22), pages 402-409, DOI: 10.1117/12.317608
[12] D.W. PRATHER, "Design and application of subwavelength diffractive lenses for integration with infrared photodetectors", Optical Engineering vol. 38 no. 5, 01 May 1999 (1999-05-01), pages 870-878, DOI: 10.1117/1.602256
[13] S.B. GLYBOVSKI, S.A. TRETYAKOV, P.A. BELOV, Y.S. KIVSHAR, AND C.R. SIMOVSKI, "Metasurfaces: From microwaves to visible", Physics Reports vol. 634, 24 May 2016 (2016-05-24), pages 1-72, DOI: 10.1016/j.physrep.2016.04.004
[14] X. ZHANG, Z. TIAN, W. YUE, J. GU, S. ZHANG, J. HAN, AND W. ZHANG, "Broadband terahertz wave deflection based on C-shape complex metamaterials with phase discontinuities", Advanced Materials vol. 25 no. 33, 6 Sep 2013 (2013-09-06), pages 4567-4572, DOI: 10.1002/adma.201204850
[15] N. YU, P. GENEVET, M.A. KATS, F. AIETA, J.P. TETIENNE, F. CAPASSO, AND Z. GABURRO, "Light propagation with phase discontinuities: generalized laws of reflection and refraction", Science vol. 334 no. 6054, 01 Sep 2011 (2011-09-01), pages 333-337, DOI: 10.1126/science.1210713
[16] Z. SONG, Z. ZHAO, H. ZHAO, W. PENG, X. HE, AND W. SHI, "Teeter-totter effect of terahertz dual modes in C-shaped complementary split-ring resonators", Journal of Applied Physics vol. 118 no. 4, 31 Jul 2015 (2015-07-31), pages 043108, DOI: 10.1063/1.4927845
[17] M. HASHEMI, A MOAZAMI, M. NASERPOUR, AND C.J. ZAPATA-RODRÍGUEZ, "A broadband multifocal metalens in the terahertz frequency range", Optics Comunications vol. 370, 01 Jul 2016 (2016-07-01), pages 306-310, DOI: 10.1016/j.optcom.2016.03.031
[18] F. AIETA, P. GENEVET, N. YU, M.A. KATS, Z. GABURRO, AND F. CAPASSO, "Out-of-plane reflection and refraction of light by anisotropic optical antenna metasurfaces with phase discontinuities", Nano letters vol. 12 no. 3, 15 Feb 2012 (2012-10-15), pages 1702-1706, DOI: 10.1021/nI300204s
[19] N.K. DHAR, S. GANGULY, AND S. KRISHNAMURTHY, "Physics of Nanostructure Design for Infrared Detectors" in "21st century nanostructured materials - physics, chemistry, classification, and emerging applications in industry, biomedicine, and agriculture" by P.V. Pham, pages 3-29, ISBN 978-1-80355-084-8
[20] M. Pfeiffer, P. Atkinson, A. Rastelli, O.G. Schmidt, H. Giessen, M. Lippitz, and K. Lindfors, "Coupling a single solid-state quantum emitter to an array of resonant plasmonic antennas", Scientific Reports vol.8 no.3415, 21 Feb 2018 (2018-10-21), pages 1-6, DOI: 10.1038/s41598-018-21664-8
[21] V. Rutckaia, F. Heyroth, A. Novikov, M. Shaleev, M. Petrov, and J. Schilling, "Quantum Dot Emission Driven by Mie Resonances in Silicon Nanostructures", Nano Letters vol. 17 no. 11, 02 Oct 2017 (2017-10-02), pages 6886-6892, DOI: 10.1021/acs.nanolett.7b03248

## Claims

1. A quantum semiconductor device, comprising at least one metasurface layer for coupling electromagnetic radiation with the quantum structure (10) for effective beam steering into the active area (11) **characterized in that** the device comprises:
- a quantum structure (10) with an active area (11) that requires matching of quantum selection rules in order to operate,
- a first sub-device (20) collecting and efficiently redirecting normal incident radiation (40) into the active area (11) of said quantum structure (10),
- a second sub-device (30) for signal reflection and additional redirection of the radiation, redirected by said first sub-device, into the active area (11) of said quantum structure (10),
wherein the first sub-device (20) and the second sub-device (30) are designed to have as large as possible electric field component along growth axis of said quantum structure (10) in the active area (11) of said quantum structure (10).

2. The quantum semiconductor device of claim 1, wherein the first sub-device (20) which provides incident radiation collection and redirection into a smaller active area (11), is located at the bottom of said quantum structure (10).

3. The quantum semiconductor device of claim 2 wherein said first sub-device, located at the bottom of said quantum structure, comprises an array of conducting, preferably metallic metasurface layer (21, 22).

4. The quantum semiconductor device of claim 2 wherein said first sub-device, located at the bottom of said quantum structure, comprises a conducting, preferably metallic complementary metasurface layer (21, 22) with an array of metacell openings.

5. The quantum semiconductor device claims 1 and 2, wherein the first sub-device (20) is located at some pre-optimised distance below said quantum structure (10).

6. The device of claim 5, wherein the first sub-device (20), located at some pre-optimised distance below said quantum structure (10), comprises an array of conducting, preferably metallic metasurface layer (24) placed on a transparent substrate (25).

7. The device of claim 5, wherein the first sub-device (20), located at some pre-optimised distance below said quantum structure (10), comprises an array of conducting, preferably metallic complementary metasurface layer (23) with an array of metacell openings.

8. The quantum semiconductor device of claim 1, wherein said second sub-device (30) is optimised to reflect and redirect signal back into an active area (11) of said quantum structure (10) and is located on the top of said quantum structure (10) and comprises a radiation-reflecting surface (31, 32, 33).

9. The device of claim 8 wherein said second sub-device (30), located on the top of said quantum structure (10) comprises an array of conducting, preferably metallic metasurface layer (33).

10. The device of claim 8 wherein said second sub-device (30), located on the top of said quantum structure (10) comprises an array of metallic complementary metasurface layer (23) with an array of metacell openings.

11. The quantum semiconductor device of any of the preceding claims, wherein the metaelement of the metasurface layer and the complementary metasurface layer are shaped, but not limited to, single or double split ring resonators, or V-shaped elements, with variable geometrical parameters that enable phase variation possibility of said metaelements.

12. The quantum semiconductor device of any of the preceding claims, wherein said electric field component along the growth axis (50) is 10, better 100, even better 1000 times larger compared to said quantum device without said first sub-device and said second sub-device.

13. Method for increasing response of quantum semiconductor device according to any of the previous claims comprises effectively coupling electromagnetic radiation to the active region (11) of the quantum semiconductor device by using of metasurface or complementary metasurface focusing elements.

14. The method of claim 13, wherein the first sub-device (20) is being optimised by changing shape and geometrical parameters of each metacell taking into account operational frequency range of said quantum semiconductor device and the position of each metacell in said metasurface layer seeking to achieve as large as possible electric field component along the growth axis (50) of said quantum structure (10) in the active area (11) of said quantum structure (10).

15. The method of claim 13 and 14, wherein the second sub-device (30) is being optimised by changing the shape and geometrical parameters of each metacell taking into account operational frequency range of said quantum device and position of each metacell in the metasurface layer and the influence of said first sub-device, for achieving as large as possible electric field component along the growth axis of said quantum structure (10) in the active area (11) of said quantum structure (10).
